# EUROPEAN PATENT APPLICATION

(11) **EP 4 539 624 A1**
(43) Date of publication of application: **16.04.2025**
(21) Application number: 23857509.6
(22) Date of filing: 21.06.2023
(51) Int. Cl.: H05K 7/20, H05K 5/00, H05K 5/03, H05K 5/06

(54) **DISPLAY DEVICE**

(30) Priority: 24.08.2022 KR 20220106278
(71) Applicant: Samsung Electronics Co., Ltd., Suwon-si, Gyeonggi-do 16677 (KR)
(72) Inventor: KIM, Dongoh, Suwon-si Gyeonggi-do 16677 (KR); LEE, Sangin, Suwon-si Gyeonggi-do 16677 (KR); LEE, Jeongryeol, Suwon-si Gyeonggi-do 16677 (KR); JEON, Jinhyeong, Suwon-si Gyeonggi-do 16677 (KR)
(74) Representative: Appleyard Lees IP LLP
(86) International application number: PCT/KR2023/008608
(87) International publication number: WO 2024/043471

(57) **Abstract**

This display device may comprise: a housing; a display module arranged inside the housing; and a control assembly for controlling the display module. The display module can comprise: a display panel; a chassis for covering the rear of the display panel; and a heat dissipation frame arranged between the chassis and the control assembly. In order to form a heat exchange space in which outside air can flow, the heat dissipation frame can comprise: a body part spaced apart from the rear surface of the chassis; and a fixing part extending from the body part so as to be fixed to the rear surface of the chassis.

## Description

### [Technical Field]

This disclosure relates to a display apparatus having an improved structure.

### [Background Art]

A display apparatus is an output apparatus that converts electrical information into visual information and displays the visual information to a user. The display apparatus may include not only a television and a monitor, but also portable devices, such as a notebook PC, a smart phone, and a tablet PC.

The display apparatus may include an emissive display panel, such as an organic light-emitting diode (OLED) panel or a non-emissive display panel, such as a liquid crystal display (LCD) panel.

A display apparatus to which a non-emissive display panel is applied may include a backlight unit that provides light to the display panel. The backlight unit may include an edge-type backlight unit in which a light source is disposed on at least one side of the display panel and a direct-type backlight unit in which a light source is disposed on the rear of the display panel.

### [Disclosure]

### [Technical Problem]

One aspect of the disclosed invention provides a display apparatus with an improved structure.

One aspect of the disclosed invention provides a display apparatus with improved productivity.

One aspect of the disclosed invention provides a display apparatus capable of reducing the number of processes and parts.

One aspect of the disclosed invention provides a display apparatus capable of achieving lightweight and slimness.

One aspect of the disclosed invention provides a display apparatus capable of easy cable connection.

The technical objectives of the present invention are not limited to the above, and other objectives that are not described above may become apparent to those of ordinary skill in the art based on the following descriptions.

### [Technical Solution]

A display apparatus according to an embodiment may include: a housing including an inlet, a display module inside the housing, and a control assembly configured to control the display module. The display module may include a display panel configured to display an image. The display module may include a chassis supporting the display panel and covering a rear of the display panel. The display module may include a heat dissipation frame between the chassis and the control assembly. The heat dissipation frame may include a body portion and a fixing portion to form a heat exchange space in which external air introduced through the inlet flows. The body portion of the heat dissipation frame may be spaced from a rear surface of the chassis. The fixing portion of heat dissipation frame may be extended from the body portion and fixed to the rear surface of the chassis.

The display apparatus may further include a sealing member configured to seal between the chassis and the fixing portion of the heat dissipation frame.

The fixing portion may further include a sealing member mounting portion that is open toward the rear surface of the chassis and into which the sealing member is inserted.

The fixing portion may be in contact with the rear surface of the chassis.

The fixing portion may extend along an edge of the body portion.

The chassis may include a first chassis body covered by the heat dissipation frame and a second chassis body exposed to a rear of the heat dissipation frame.

The display module may further include a cable that passes through the second chassis body and is electrically connected to the control assembly.

The display apparatus may further include a bracket detachably mountable to the heat dissipation frame and configured to fix the housing and the display module.

The heat dissipation frame may further include a first coupling portion on a rear surface of the heat dissipation frame. The bracket may further include a second coupling portion hook-coupled to the first coupling portion.

The first coupling portion may include a locking protrusion protruding toward a rear of the heat dissipation frame. The second coupling portion may include a locking groove configured to engage with the locking protrusion.

The first coupling portion may further include a receiving groove recessed toward a front of the heat dissipation frame. The second coupling portion may further include a protruding rib protruding toward the front of the heat dissipation frame to be received in the receiving groove.

The heat dissipation frame may further include a guide protrusion protruding toward a rear of the heat dissipation frame. The bracket may further include a guide hole corresponding to the guide protrusion. The bracket may be configured to be held on the heat dissipation frame as the guide protrusion is inserted into the guide hole.

The housing may include a front cover arranged to protect a front of the display module. The housing may include a rear cover coupled to a rear of the front cover and covering a rear of the display module and the control assembly. A first space between the chassis and the rear cover may be communicable with a second space between the heat dissipation frame and the rear cover.

The heat dissipation frame may be injection-molded.

The heat dissipation frame may include a plastic material.

A display apparatus according to an embodiment may include: a housing including an opening, a control assembly arranged inside the housing, a display panel configured to display an image through the opening and controllable by the control assembly, a chassis configured to cover a rear of the display panel, a heat dissipation frame configured to form a cooling path partitioned from the control assembly and configured to be fixed while in contact with a rear surface of the chassis, and a bracket configured to fix the heat dissipation frame to the housing and hook-coupled to a rear surface of the heat dissipation frame.

The display apparatus may further include a sealing member configured to seal between the chassis and the heat dissipation frame. The heat dissipation frame may include a body portion spaced from the rear surface of the chassis, and a fixing portion extending from the body portion toward the rear surface of the chassis and to which the sealing member is mounted.

The housing may further include a side portion configured to cover an edge of the display panel. The bracket may be disposed between the side portion of the housing and the body portion of the heat dissipation frame. The bracket may have a shape extending along the side portion of the housing.

The chassis may include a first chassis body covered by the heat dissipation frame, and a second chassis body other than the first chassis body. The second chassis body may be exposed to the rear of the heat dissipation frame.

The housing may further include an inlet and an outlet. The heat dissipation frame may include a first opening configured to guide external air introduced through the inlet to the cooling path. The heat dissipation frame may further include a second opening configured to guide air flowing through the cooling path to the outlet.

### [Advantageous Effects]

A display apparatus according to one embodiment can have a simplified heat dissipation structure.

A display apparatus according to one embodiment can achieve improved productivity.

A display apparatus according to one embodiment can reduce the number of processes and parts.

A display apparatus according to one embodiment can be lightweight and slim.

A display apparatus according to one embodiment may have easy cable connection.

The effects of the present disclosure are not limited to the effects described above, and other effects that are not described will be clearly understood by those skilled in the art from the following description.

### [DESCRIPTION OF DRAWINGS]

FIG. 1 is a perspective view of an example of a display apparatus according to an embodiment.
FIG. 2 is a rear perspective view of an example of a display apparatus according to an embodiment.
FIG. 3 is an exploded view of an example of a display apparatus according to an embodiment.
FIG. 4 is an exploded view of an example of a display module.
FIG. 5 is an exploded view of the display module shown in FIG. 4, when viewed from the rear.
FIG. 6 is a side cross-sectional view of an example of a display apparatus according to an embodiment.
FIG. 7 is a plan cross-sectional view of an example of a display apparatus according to an embodiment.
FIG. 8 is an enlarged view of a portion of FIG. 7.
FIG. 9 is a rear view of an example of a display apparatus with a rear chassis omitted.
FIG. 10 is a view illustrating an example of a cable connection of a display apparatus.
FIG. 11 is a drawing illustrating an example of a coupling state between a display module and a bracket.
FIG. 12 is an enlarged view of a portion of FIG. 11.
FIG. 13 is a view of the display module and the bracket shown in FIG. 12, when viewed in a different direction.
FIG. 14 is an enlarged view of a portion of an example of the display module.
FIG. 15 is a perspective view of an example of a bracket.

### [Modes of the Invention]

Embodiments described in the disclosure and configurations illustrated in the drawings are merely examples of the embodiments of the disclosure, and may be modified in various different ways at the time of filing of the present application to replace the embodiments and drawings of the disclosure.

In addition, the same reference numerals or signs illustrated in the drawings of the disclosure indicate elements or components performing substantially the same function.

Also, the terms used herein are used to describe the embodiments and are not intended to limit and / or restrict the disclosure. The singular forms "a," "an" and "the" are intended to include the plural forms as well, unless the context clearly indicates otherwise. In this disclosure, the terms "comprising", "including", "having", and the like are used to specify features, numbers, steps, operations, elements, components, or combinations thereof, but do not preclude the presence or addition of one or more of the features, elements, steps, operations, elements, components, or combinations thereof.

It will be understood that when an element is referred to as being "connected" another element, it may be directly or indirectly connected to the other element. Similarly, it will be understood that when an element is referred to as being "coupled" another element, it may be directly or indirectly coupled to the other element.

Throughout the description, when a member is located "on" another member, this includes not only when the member is in contact with the other member, but also when there is another member between the two members.

It will be understood that, although the terms first, second, third, etc., may be used herein to describe various elements, but elements are not limited by these terms. These terms are only used to distinguish one element from another element. For example, without departing from the scope of the disclosure, a first element may be termed as a second element, and a second element may be termed as a first element. The term of "and / or" includes a plurality of combinations of relevant items or any one item among a plurality of relevant items.

Meanwhile, the terms "up and down direction", "height direction", "vertical direction", "horizontal direction", "upper direction", "lower direction", and "front and rear direction" used in the following description are defined based on the drawings, but the shape and position of each component are not limited by this term. For example, the +X direction may be defined as forward and the -X direction as backward. For example, the +Y direction may be defined as right and the -Y direction as left. For example, the +Z direction may be defined as up and the -Z direction as down.

Hereinafter, embodiments of the present disclosure will be described in detail with reference to the attached drawings.

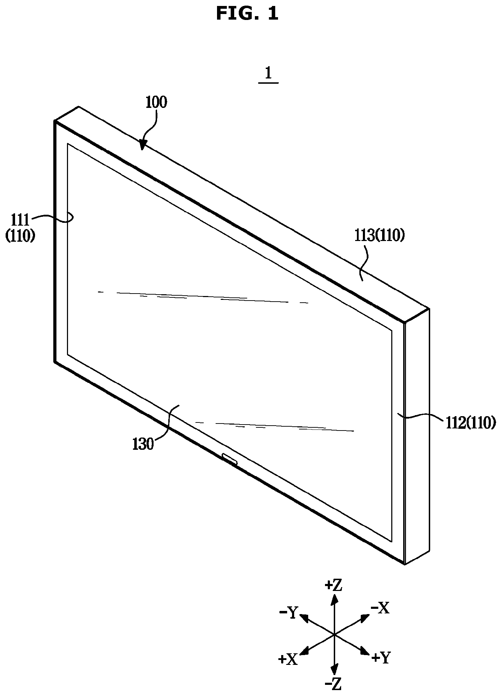

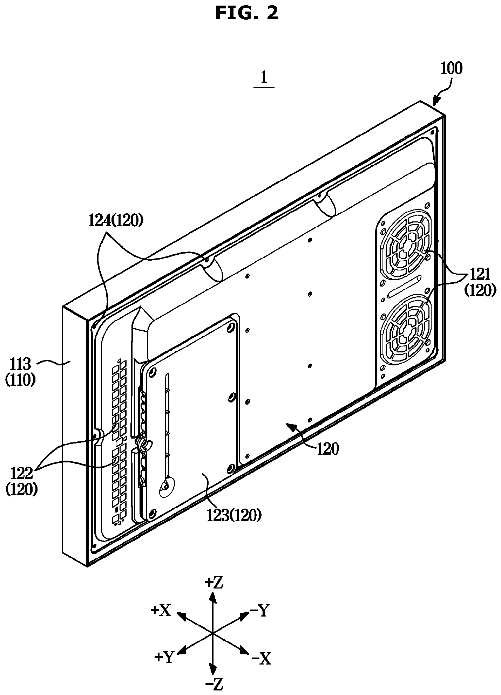

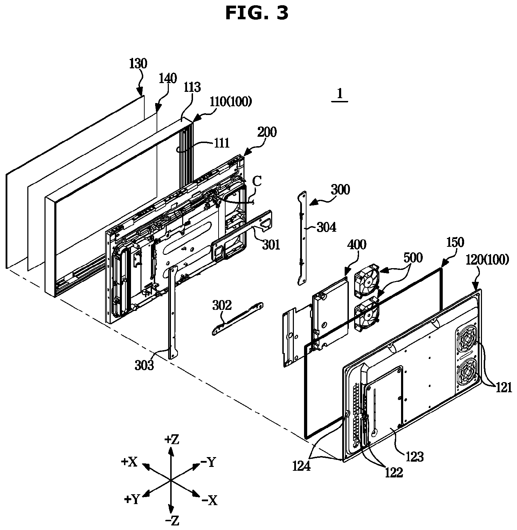

FIG. 1 is a perspective view of an example of a display apparatus according to one embodiment. FIG. 2 is a rear perspective view of an example of a display apparatus according to one embodiment. FIG. 3 is an exploded view of an example of a display apparatus according to one embodiment.

The display apparatus 1 is an apparatus that may process an image signal received from the outside and may visually display the processed image. For example, the display apparatus 1 may be implemented in various forms, such as a television TV, a monitor, a portable multimedia device, a portable communication device, a portable computing device, and the like. The form of the display apparatus 1 is not limited as long as it is a device that visually displays an image.

The display apparatus 1 may receive video signals and audio signals from various content sources and output video and audio corresponding to the video signals and audio signals. For example, the display apparatus 1 may receive television broadcast content through a broadcast receiving antenna or a wired cable, receive content from a content playback device, or receive content from a content provision server of a content provider.

The display apparatus 1 may be a flat display apparatus having a flat screen, or a curved display apparatus having a curved screen. The display apparatus 1 may have a screen that may change from a flat state to a curved state. The display apparatus 1 may have a screen that may change from a curved state to a flat state. The display apparatus 1 may be a bendable display apparatus with a curvature of a curved screen that is changeable.

Referring to FIGS. 1 to 3, the display apparatus 1 may include a housing 100. The housing 100 may form an external appearance of the display apparatus 1. The housing 100 may be arranged to accommodate components for the operation of the display apparatus 1. The housing 100 may accommodate a display module 200. The housing 100 may accommodate a control assembly 400. The housing 100 may accommodate a fan 500.

For example, the housing 100 may be arranged to be located outdoors. However, it is not limited thereto, and the housing 100 may be arranged to be located indoors as needed.

The housing 100 may include a front cover 110. The front cover 110 may be provided to accommodate at least a portion of the display module 200. The front cover 110 may be provided to protect the front of the display module 200.

The front cover 110 may include an opening 111. For example, the opening 111 may be provided to pass from a front surface to a rear surface of the front cover 110. An image displayed on the display module 200 may be viewed to the outside through the opening 111.

The front cover 110 may include a bezel portion 112. The bezel portion 112 may be provided to cover a front periphery of the display module 200.

The front cover 110 may include a side portion 113. The side portion 113 may be provided to cover a side area of the display module 200. The side portion 113 may be provided to cover edges of the display panel 210 of the display module 200. For example, the side portion 113 may be folded rearward from the periphery of the bezel portion 112. For example, the side portion 113 may be provided to have four sides.

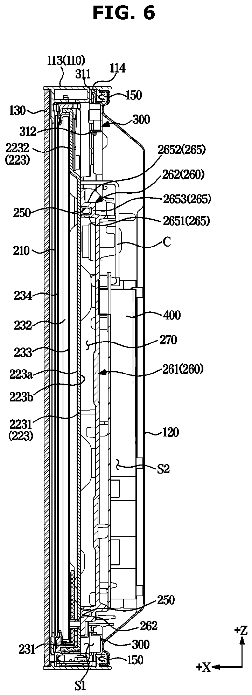

A bracket 300 to be described below may be coupled to the side portion 113. For example, the side portion 113 may form a coupling groove 114 to which a first side 311 of the bracket 300 to be described below may be fixed (see FIGS. 6, 8, and 10).

The display apparatus 1 may include glass 130. The glass 130 may be provided to protect the front surface of the display module 200. The glass 130 may be provided to have sufficient rigidity. For example, when the display apparatus 1 is provided outdoors, the glass 130 may prevent rain, snow, foreign substances, and the like from penetrating into the display module 200.

The glass 130 may be provided at the front of the display module 200. The glass 130 may be mounted at the opening 111 of the front cover 110. For example, the glass 130 may be mounted on the front cover 110 by an adhesive member 610.

In the drawing, the glass 130 is illustrated as being a separate component from the front cover 110, but it is not limited thereto. For example, the glass 130 may be provided as a part of the front cover 110.

The display apparatus 1 may include a polarizing film 140. The polarizing film 140 may polarize external light introduced through the glass 130. The polarizing film 140 may allow only a portion of sunlight to pass therethrough. The light passing through the polarizing film 140 may be provided to have a certain directionality.

In the drawing, the polarizing film 140 is illustrated as being a separate component from the front cover 110, but is not limited thereto. The polarizing film 140 may be arranged as a part of the front cover 110.

The display apparatus 1 may include a rear cover 120. The housing 100 may include the rear cover 120. The rear cover 120 may be separably coupled to the front cover 100. The rear cover 120 may be provided to cover the rear of the display module 200. The rear cover 120 may be provided to cover the rear of the control assembly 400. The rear cover 120 may be provided to cover the rear of the fan 500.

The rear cover 120 may include an inlet 121 through which external air is introduced. The inlet 121 may be formed at a position corresponding to the fan 500. The air introduced through the inlet 121 may be provided to cool the display apparatus 1. The air introduced through the inlet 121 may be provided to cool the display module 200. The air introduced through the inlet 121 may be provided to cool the control assembly 400.

The rear cover 120 may include an outlet 122 through which air inside the housing 100 is discharged. The air flowing inside the housing 100 may be discharged to the outside of the display apparatus 1 through the outlet 122. The air having cooled the inside of the display apparatus 1 may be discharged to the outside of the display apparatus 1 through the outlet 122. The air having has cooled the display module 200 may be discharged to the outside of the display apparatus 1 through the outlet 122. The air having cooled the control assembly 400 may be discharged to the outside of the display apparatus 1 through the outlet 122.

In the drawing, the inlet 121 and the outlet 122 are illustrated as being spaced apart in the left-right direction, but this is not limited thereto. For example, the inlet 121 and the outlet 122 may be spaced apart in the upper-lower direction.

The rear cover 120 may include a connector cover 123. The connector cover 123 may be provided to cover a space in which a connector (not shown) is provided. For example, a connector of the display apparatus 1 may be accessible through the connector cover 123.

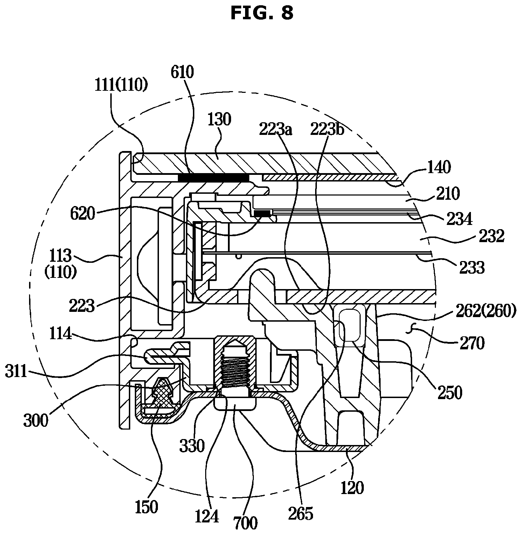

The rear cover 120 may include a coupling hole 124. The rear cover 120 may be fixed to the front cover 110 through the coupling hole 124. For example, the coupling hole 124 of the rear cover 120 may be provided to correspond to a coupling hole 330 of the bracket 300 to be described below (see FIG. 8).

The display apparatus 1 may include a first sealing member 150. The first sealing member 150 may be separably mounted to the housing 100. The first sealing member 150 may be provided to seal between the front cover 110 and the rear cover 120. For example, the first sealing member 150 may have a shape extending along the edge of the housing 100. For example, the first sealing member 150 may have a closed loop shape.

The display apparatus 1 may include a display module 200. The display module 200 may be arranged inside the housing 100. The display module 200 may be arranged at the rear of the glass 130. The display module 200 may be arranged at the rear of the polarizing film 140. The display module 200 may be provided to display an image. Details thereof will be described below.

The display apparatus 1 may include a bracket 300. The bracket 300 may be coupled to the housing 100. The bracket 300 may be coupled to the display module 200. The bracket 300 may be coupled to a heat dissipation frame 260 of the display module 200 to be described below.

For example, the bracket 300 may be arranged to fix the housing 100 and the display module 200. The bracket 300 may fix the display module 200 to the front cover 110. The bracket 300 may fix the rear cover 120 to the front cover 110.

The bracket 300 may be provided as at least one bracket 300. For example, the bracket 300 may include a first bracket 301 located at a rear upper side of the display module 200. The bracket 300 may include a second bracket 302 located at a rear lower side of the display module 200. The bracket 300 may include a third bracket 303 located at a rear right side of the display module 200. The bracket 300 may include a fourth bracket 304 located at a rear left side of the display module 200. However, this is not limited thereto, and one or more brackets 300 may be provided. In addition, the shape and position of the bracket 300 are not limited to those shown in the drawing.

The display apparatus 1 may include a control assembly 400. The control assembly 400 may be provided to supply power for driving the display apparatus 1 or to control the operation of the display apparatus 1. For example, the control assembly 400 may be provided to drive and control the display module 200. For example, the control assembly 400 may be provided to include at least one of a main board, a power board, and a driver.

The control assembly 400 may be arranged inside the housing 100. The control assembly 400 may be arranged at the rear of the display module 200. The control assembly 400 may be arranged between the display module 200 and the rear cover 120. The control assembly 400 may be held on a rear surface 260b of the heat dissipation frame 260 described below.

The display apparatus 1 may include a fan 500. The fan 500 may be configured to generate a blowing power. The fan 500 may allow air to flow into the housing 100 through the inlet 121. The fan 500 may allow air to flow out of the housing 100 through the outlet 122. For example, the fan 500 may be a centrifugal fan that draws in air in an axial direction and discharges the air in a radial direction. However, the fan 500 is not limited in the type as long as it can flow air.

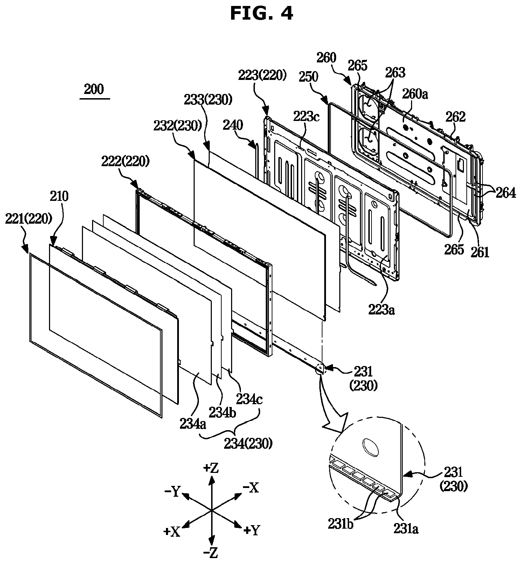

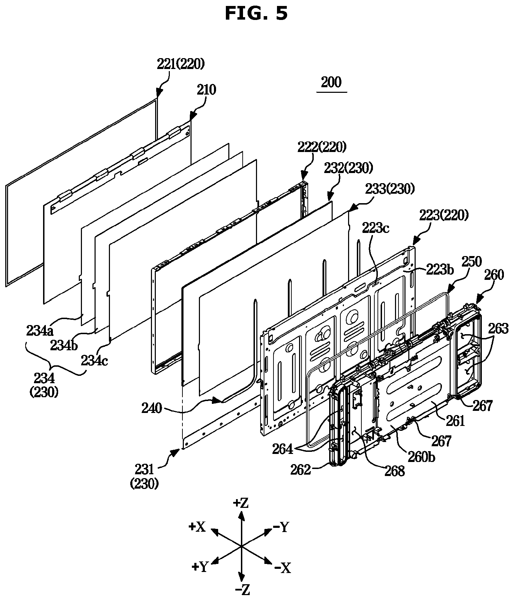

FIG. 4 is an exploded view of an example of a display module. FIG. 5 is an exploded view of the display module shown in FIG. 4, when viewed from the rear.

The display module 200 may include a display panel 210.

The display panel 210 may be provided to display an image. The display panel 210 may be provided to display an image through the opening 111 of the housing 100.

For example, the display panel 210 may include a liquid crystal display panel (LCD Panel), a light emitting diode panel (LED Panel), or an organic light emitting diode panel (OLED Panel). However, the present disclosure is not limited thereto.

The display panel 210 may include a thin film transistor substrate in which thin film transistors are formed in a matrix form. The display panel 210 may include a color filter substrate that is coupled in parallel with the thin film transistor substrate. The display panel 210 may include liquid crystal molecules that are injected between the thin film transistor substrate and the color filter substrate and whose optical properties change depending on changes in voltage or temperature.

The display panel 210 may be accommodated in a chassis 220 described below. For example, the display panel 210 may be mounted on the chassis by an adhesive member 620.

The display module 200 may include a backlight unit 230. The backlight unit 230 may be provided to supply the display panel 210 with light.

The backlight unit 230 may include a light source device 231 provided to supply light to the display panel 210.

For example, referring to FIGS. 4 and 5, the backlight unit 230 may be an edge type backlight unit in which the light source device 231 is disposed on at least one side of the display panel 210. However, different from that shown in the drawing, the backlight unit 230 may be provided as a direct type backlight unit in which the light source device 231 is disposed directly below the display panel 210.

The light source device 231 may include a substrate 231a and a light source 231b mounted on the substrate 231a to emit light.

The substrate 231a may be provided to mount the light source 231b thereon. The substrate 231a may include a printed circuit board (PCB). A circuit pattern (not shown) for transmitting driving power and signals to the light source 231b may be formed on the substrate 231a. The substrate 231a may be provided to be mounted on the chassis 220 to be described below.

The light source 231b may be provided to emit light. For example, the light source 231b may be provided as a plurality of light sources 231b. For example, the plurality of light sources 231b may be mounted in a row on the substrate 231a.

The light source 231b may include a light emitting diode (LED). The light source 231b may include a cold cathode fluorescent lamp (CCFL). The light source 231b may include an external electrode fluorescent lamp (EEFL). The light source 231b may be provided in the form of a package in which a chip is mounted on a substrate 231a and filled with a resin.

The backlight unit 230 may include an optical member arranged on a path of light emitted from the light source device 231. The optical member may be provided at the rear of the display panel 210. The optical member may guide the direction of light propagation. The optical member may reflect light. The optical member may diffuse light. The optical member may improve optical characteristics.

The optical member may include a light guide panel (LGP) 232. The light guide plate 232 may be provided to guide light to the display panel 210. The light guide plate 232 may evenly diffuse light coming from the light source device 231. The light guide plate 232 may perform a function of improving color reproducibility.

The light guide plate 232 may be formed of polymethyl methacrylate (PMMA) material. The light guide plate 232 may be provided with a pattern to change the path of light. In the edge-type backlight unit, the light source device 231 may be located at the side of the light guide plate 232. For example, light incident to the side of the light guide plate 232 may be scattered by a pattern formed on the rear surface of the light guide plate 232 and may be emitted through the front surface of the light guide plate 232.

The optical member may include a reflective sheet 233. The reflective sheet 233 may be provided to reflect light emitted from the light source 231b. The reflective sheet 233 may be provided to reflect light emitted from the light guide plate 232 to the rear.

The optical member may include an optical sheet 234. The optical sheet 234 may improve optical characteristics, such as enhancing brightness.

For example, the optical sheet 234 may include a diffusion sheet. The diffusion sheet may evenly diffuse irregular light generated from the light source device 231. The diffusion sheet may allow incident light to be evenly diffused and emitted.

For example, the optical sheet 324 may include a quantum dot sheet. The quantum dot sheet may change the wavelength of light to improve color reproducibility. Inside the quantum dot sheet, quantum dots, which are semiconductor crystals several nanometers in size that emit light, may be dispersed and arranged. For example, quantum dots may receive blue light and generate all colors of visible light depending on their size. The smaller the quantum dot, the shorter the wavelength light may be generated, and the larger the quantum dot, the longer the wavelength light may be generated.

For example, the optical sheet 234 may include a prism sheet. The prism sheet may focus light to improve brightness.

For example, the optical sheet 324 may include a protection sheet. The protection sheet may protect other optical sheets from external impact or foreign substances.

For example, the optical sheet 324 may include a reflective polarizing sheet (dual brightness enhancement film: DBEF). The reflective polarizing sheet may improve brightness by transmitting one polarized light while reflecting the other polarized light.

However, it is not limited to the examples described above, and the optical sheet 234 may be provided to include various types of sheets that may improve optical characteristics.

The optical sheet 324 may be provided as one or more optical sheets. In the drawing, three optical sheets 324a, 324b, and 324c are illustrated, but the number of the optical sheets is not limited thereto. The optical sheet 324 may be provided as one or more optical sheets.

**In** the drawing, the display apparatus 1 is illustrated as a non- emissive display apparatus including a backlight unit 230, but this is only an example. The display apparatus 1 may be an emissive display apparatus. When the display apparatus 1 is an emissive display apparatus, the backlight unit 230 may be omitted.

The display module 200 may include a chassis 220. The chassis 220 may be provided to support the display panel 210. The chassis 220 may be provided to accommodate the display panel 210. The chassis 220 may be provided to cover the rear of the display panel 210. The chassis 220 may be provided to support the backlight unit 230. The chassis 220 may be provided to accommodate the backlight unit 230. The chassis 220 may be provided to cover the rear of the backlight unit 230.

For example, the chassis 220 may include at least one of a front chassis 221, a rear chassis 223, and a middle mold 222. Some of the front chassis 221, the rear chassis 223, and the middle mold 222 may be omitted. Some of the front chassis 221, the rear chassis 223, and the middle mold 222 may be provided as a single part.

The rear chassis 223 may be provided to support the backlight unit 230. The rear chassis 223 may be provided to support the display panel 210. The rear chassis 223 may be provided to cover the rear of the backlight unit 230. When the backlight unit 230 is omitted, the rear chassis 223 may be provided to cover the rear of the display panel 210. For example, the rear chassis 223 may have a plate shape with an edge approximately folded forward.

The rear chassis 223 may have a function of dissipating heat generated from a heat-generating element, such as the light source device 231 to the outside. For example, the rear chassis 223 may include at least one of various metal materials, such as aluminum, stainless steel (SUS), or plastic materials, such as acrylonitrile butadiene Styrene (ABS).

The rear chassis 223 may include a cable hole 223c provided to pass from a front surface 223a and a rear surface 223b. A cable C of the display module 200 to be described below may be provided to pass through the cable hole 223c of the rear chassis 223.

The front chassis 221 may be provided to be coupled to the front of the rear chassis 223. For example, the front chassis 221 may be provided to support the display panel 210. For example, the front chassis 221 may have a frame shape having an opening such that light from the backlight unit 230 is provided to the display panel 210.

The middle mold 222 may be coupled to the front chassis 221 and the rear chassis 223. The backlight unit 230 may be accommodated between the rear chassis 223 and the front chassis 221.

The middle mold 222 may be provided to support the optical sheet 234. The middle mold 222 may maintain a gap between the optical sheet 234 and the light source device 231. The middle mold 222 may be coupled to the front chassis 221 and the rear chassis 223. For example, the middle mold 222 may have a frame shape having an opening.

The display module 200 may include a heat sink 240. The heat sink 240 may be provided to dissipate heat generated from the backlight unit 230. The heat sink 240 may be provided to dissipate heat generated from the light source device 231. For example, the heat sink 240 may include a metal material having superior heat dissipation properties. For example, the heat sink 240 may include an aluminum material. For example, the heat sink 240 may include a graphite material.

The heat sink 240 may be provided inside the chassis 220. For example, the heat sink 240 may be arranged between the reflective sheet 233 and the rear chassis 223. For example, the heat sink 240 may be separably mounted on the front surface 223a of the rear chassis 223.

The heat sink 240 may have a shape extending in the vertical direction (Z direction). The heat sink 240 may have a shape extending in the left-right direction (Y direction). The heat sink 240 may include an approximately L-shaped shape. However, the present disclosure is not limited thereto, and the heat sink 240 may include various shapes for heat dissipation.

The display module 200 may include a heat dissipation frame 260. The heat dissipation frame 260 may be provided as a component of the display module 200 to prevent degradation of the display apparatus 1. The heat dissipation frame 260 may be provided to prevent degradation of the display module 200. The heat dissipation frame 260 may be provided to prevent degradation of the control assembly 400. The heat dissipation frame 260 may be provided to lower the internal temperature of the housing 100. The heat dissipation frame 260 may be provided to form a heat exchange space 270. Details thereof will be given below.

The heat dissipation frame 260 may be arranged at the rear of the chassis 220. The heat dissipation frame 260 may be arranged between the chassis 220 and the control assembly 400. The heat dissipation frame 260 may be arranged between the rear chassis 223 and the control assembly 400. The heat dissipation frame 260 may be arranged between the rear chassis 223 and the rear cover 120.

The heat dissipation frame 260 may be fixed to the rear surface of the chassis 220. The heat dissipation frame 260 may be fixed to the rear surface of the chassis 220 and may be provided as a single body with the chassis 220. For example, the heat dissipation frame 260 may be coupled to the rear surface 223b of the rear chassis 223.

For example, the heat dissipation frame 260 may be injection-molded. The heat dissipation frame 260 may be provided as an injection-molded product. For example, the heat dissipation frame 260 may include a plastic material. Accordingly, the heat dissipation frame 260 may be easily manufactured even with a complex shape.

For example, the heat dissipation frame 260 may have a plate shape with an edge that is approximately folded forward. The heat dissipation frame 260 may include a body portion 261 spaced apart from the chassis 220. The heat dissipation frame 260 may include a fixing portion 262 extending forward from the body portion 261. Details thereof will be described below.

The heat dissipation frame 260 may include a first opening 263 corresponding to the inlet 121. The first opening 263 may be provided to pass from a front surface 260a to a rear surface 260b of the heat dissipation frame 260. A fan 500 may be separably mounted to the first opening 263. The first opening 263 may be provided to guide external air introduced through the inlet 121 to the heat exchange space 270. The first opening 263 may be referred to as an inlet opening 263.

The heat dissipation frame 260 may include a second opening 264 corresponding to the outlet 122. The second opening 264 may be provided to pass through the front surface 260a to the rear surface 260b of the heat dissipation frame 260. The second opening 264 may be provided to guide air flowing through the heat exchange space 270 to the outlet 122. The second opening 264 may be referred to as an outlet opening 264.

The heat dissipation frame 260 may include a holder portion 267. The control assembly 400 may be held on the holder portion 267. The control assembly 400 may be separably mounted on the holder portion 267. For example, the holder portion 267 may protrude from the rear surface 260b of the heat dissipation frame 260.

The heat dissipation frame 260 may include a connector receiving portion 268. The connector receiving portion 268 may be provided to receive a connector (not shown). The connector receiving portion 268 may be covered by the rear cover 120. The connector receiving portion 268 may be covered by the connector cover 123 of the rear cover 120. The connector receiving portion 268 may be provided to be accessible through the connector cover 123.

The display module 200 may include a second sealing member 250. The second sealing member 250 may be provided to seal between the chassis 220 and the heat dissipation frame 260. The second sealing member 250 may be provided to seal between the chassis 220 and the fixing portion 262 of the heat dissipation frame 260. The second sealing member 250 may be provided to seal between the rear chassis 223 of the chassis 220 and the fixing portion 262 of the heat dissipation frame 260. For example, the second sealing member 250 may be provided to be inserted into the fixing portion 262. For example, the second sealing member 250 may have a shape that extends along the edge of the heat dissipation frame 260. For example, the second sealing member 250 may have a shape that extends along the fixing portion 262 of the heat dissipation frame 260. For example, the second sealing member 250 may have a closed loop shape.

The display module 200 may include a cable C (see FIG. 3). The cable C may electrically connect the display module 200 and the control assembly 400. For example, the cable C may electrically connect the display panel 210 and the control assembly 400. For example, the cable C may connect the backlight unit 230 and the control assembly 400.

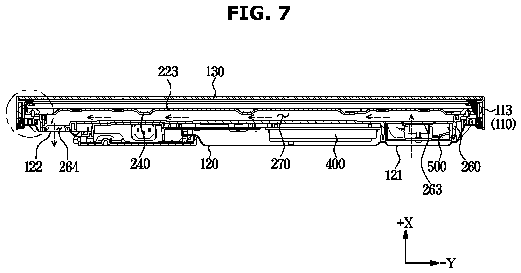

FIG. 6 is a side cross-sectional view of an example of a display apparatus according to one embodiment. FIG. 7 is a plan cross-sectional view of an example of a display apparatus according to one embodiment. FIG. 8 is an enlarged view of a portion of FIG. 7.

Referring to FIGS. 6 to 8, the heat dissipation frame 260 may be provided to form a heat exchange space 270.

For example, when the display apparatus 1 is arranged outdoors, sunlight incident on the front of the display apparatus 1 may increase the temperature of the display panel 210. For example, the backlight unit 230 may act as a heating element in the process of supplying light to the display panel 210 to increase the internal temperature of the housing 100. For example, the control assembly 400 may emit heat during the process of driving and controlling the display module 200 to increase the internal temperature of the housing 100. Due to the examples described above, the display apparatus 1 may be degraded.

The heat dissipation frame 260 may form the heat exchange space 270 to prevent degradation of the display apparatus 1. The heat dissipation frame 260 may be coupled to the rear chassis 223 to form the heat exchange space 270. The heat exchange space 270 may be provided at the rear of the rear chassis 223. The heat exchange space 270 may be surrounded by the rear chassis 223 and the heat dissipation frame 260. The heat exchange space 270 may be partitioned d from the control assembly 400.

Referring to FIG. 7, external air introduced through the inlet 121 may be provided to flow in the heat exchange space 270. The external air may be provided to exchange heat with the display module 200 while flowing through the heat exchange space 270. The external air may be provided to cool the display module 200 while flowing through the heat exchange space 270. The external air may be provided to exchange heat with the control assembly 400 while flowing through the heat exchange space 270. The external air may be provided to cool the control assembly 400 while flowing through the heat exchange space 270. The internal temperature of the housing 100 may be lowered by the flow of the external air. The heat exchange space 270 may be referred to as a cooling path 270.

For example, by the suction force of the fan 500, the external air may be drawn into the heat exchange space 270 through the inlet 121 and the first opening 263. The air that has exchanged heat with the display module 200 and/or the control assembly 400 while flowing through the heat exchange space 270 may be discharged to the outside of the display apparatus 1 through the second opening 264 and the outlet 122. The air that has cooled the display module 200 and/or the control assembly 400 while flowing through the heat exchange space 270 may be discharged to the outside of the display apparatus 1 through the second opening 264 and the outlet 122.

In FIG. 7, the air is illustrated as flowing in the left-right direction (Y direction) in the heat exchange space 270, but it is not limited thereto. The direction of air flow may be changed depending on the positions of the inlet 121, the outlet 122, and the fan 500. For example, when the inlet 121 and the outlet 122 are arranged in a vertical direction, the air may be provided to flow in a vertical direction (Z direction) in the heat exchange space 270.

The heat dissipation frame 260 may include the body portion 261 and the fixing portion 262 to form a heat exchange space 270.

The body portion 261 may be spaced rearward from the chassis 220. The body portion 261 may be spaced apart from the rear surface of the chassis 220. The body portion 261 may be spaced rearward from the rear surface 223b of the rear chassis 223.

The fixing portion 262 may be extended from the body portion 261 and fixed to the chassis 220. The fixing portion 262 may be extended from the body portion 261 and fixed to the rear surface of the chassis 220. The fixing portion 262 may be extended forward from the body portion 261 and fixed to the rear surface 223b of the rear chassis 223. The fixing portion 262 may be provided to contact the chassis 220. The fixing portion 262 may be provided to contact the rear surface 223b of the rear chassis 223.

The fixing portion 262 may be provided to seal an area, except for a portion for inflow and outflow of air, in the heat exchange space 270. That is, air flowing in the heat exchange space 270 may not leak through an area except for the first opening 263 and the second opening 264. As a result, the external air and the display apparatus 1 may effectively exchange heat.

For example, the fixing portion 262 may be provided on the edge of the body portion 261. For example, the fixing portion 262 may extend along the edge of the body portion 261. For example, the fixing portion 262 may be provided to be bent forward from the edge of the body portion 261. For example, the fixing portion 262 may be provided to surround the body portion 261.

The fixing portion 262 may include a sealing member mounting portion 265. The second sealing member 250 may be separably mounted on the sealing member mounting portion 265. For example, the second sealing member 250 may be inserted into the sealing member mounting portion 265.

The sealing member mounting portion 265 may be open toward the chassis 220. The sealing member mounting portion 265 may be open toward the rear surface of the chassis 220. The sealing member mounting portion 265 may be open toward the rear surface 223b of the rear chassis 223. The sealing member mounting portion 265 may have a shape that is depressed toward the rear of the heat dissipation frame 260. For example, the sealing member mounting portion 265 may be provided as a groove.

For example, the fixing portion 262 may include a first extension portion 2651, a second extension portion 2652, and a connecting portion 2653 that connects the first extension portion 2651 and the second extension portion 2652. The first extension portion 2651 may be in contact with the rear surface 223b of the rear chassis 223. The first extension portion 2651 may have a shape that extends in the forward-backward direction (X direction). The second extension portion 2652 may be in contact with the rear surface 223b of the rear chassis 223. The second extension portion 2652 may have a shape that extends in the forward-backward direction (X direction). The second extension portion 2652 may be spaced outwardly from the first extension portion 2651. The first extension portion 2651, the second extension portion 2652, and the connecting portion 2653 may form the sealing member mounting portion 265.

The display apparatus may form a heat exchange space, in which external air circulates, as a heat dissipation structure. In general, in the related technologies, a rear cover is arranged between a display module and a control assembly to form a heat exchange space. The rear cover is connected to the front cover to be spaced apart from the display module to form a heat exchange space. In this case, since the control assembly is exposed to the rear of the rear cover, an additional cover part is required to protect the control assembly. In addition, in order to seal an area, except for a portion for the inflow and outflow of air, in the heat exchange space, a number of bracket parts and additional processes (e.g., welding, caulking, and the like) are required. For example, a partition is provided between the display module and the rear cover. In order to form the partition, a sealing member and a sealing member bracket for fixing the sealing member are required. In addition, additional sealing processes are required to prevent moisture from penetrating into the joints of the display module, the rear cover, and the partition.

In comparison, the display apparatus 1 may include the heat dissipation frame 260 provided as a component of the display module 200 (see FIG. 3). The heat dissipation frame 260 may be fixed to the rear surface of the chassis 220 to form the heat exchange space 270 between the chassis 220 and the control assembly 400. The rear cover 120 may be coupled to the front cover 110 to cover the rear of the display module 200 and the control assembly 400. As a result, a separate cover part for protecting the control assembly 400 is not required. In addition, the fixing portion 262 of the heat dissipation frame 260 may be fixed to the rear surface of the chassis 220 to seal the heat exchange space 270 except for the air inlet and outlet portions. As a result, a separate partition is not required. That is, a number of bracket parts and additional processes may be omitted. The number of parts and processes for manufacturing the display apparatus 1 may be reduced. In addition, the display apparatus 1 may become slim and lightweight overall.

Meanwhile, in the related technology, the rear cover forming the heat exchange space is formed by a press method, and thus has a limited shape. Accordingly, in order for the rear cover to seal the heat exchange space, additional bracket parts and/or additional processes are required. In comparison, the heat dissipation frame 260 forming the heat exchange space according to the present disclosure may be formed by an injection method, and thus may have a more complex shape. For example, the heat dissipation frame 260 may include a shape that is fixed to and be in contact with the rear surface of the chassis 220 while forming the heat exchange space 270. For example, the heat dissipation frame 260 may include the body portion 261 and the fixing portion 262. That is, only with the shape of the heat dissipation frame 260, the area except for the part for air inflow and outflow in the heat exchange space 270 may be sealed, and thus additional bracket parts and/or additional processes may be omitted. As a result, the productivity and workability of the display apparatus 1 may be improved.

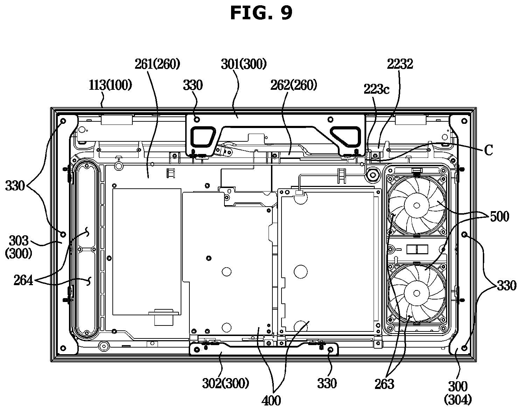

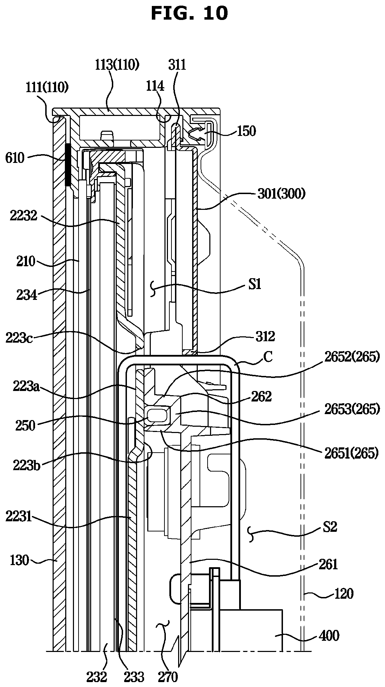

FIG. 9 is a rear view of an example of a display apparatus with a rear chassis omitted. FIG. 10 is a view illustrating an example of a cable connection of a display apparatus.

The size of the heat dissipation frame 260 may be smaller than the size of the chassis 220. The heat dissipation frame 260 may be provided to cover a part of the rear side of the chassis 220. Accordingly, a part of the chassis 220 that is not covered by the heat dissipation frame 260 may be exposed to the rear of the heat dissipation frame 260.

The chassis 220 may include a first chassis body 2231 that is provided to be covered by the heat dissipation frame 260. For example, the first chassis body 2231 may be provided as a part of the rear chassis 223.

The chassis 220 may include a second chassis body 2232 that is provided not to be covered by the heat dissipation frame 260. The second chassis body 2232 may be provided to be exposed to the rear of the heat dissipation frame 260. The second chassis body 2232 may be an area of the chassis 220 other than the first chassis body 2231. For example, the second chassis body 2232 may be provided as a part of the rear chassis 223.

The cable C may pass through the chassis 220 and be electrically connected to the control assembly 400. The cable C may pass through the second chassis body 2232 and be electrically connected to the control assembly 400. For example, the cable C may be provided to pass through the cable hole 223c formed in the second chassis body 2232. The cable C may be provided not to interfere with the heat dissipation frame 260.

For example, a first space S1 formed between the chassis 220 and the rear cover 120 may communicate with a second space S2 formed between the chassis 220 and the rear cover 120. The control assembly 400 may be provided in the second space S2. The cable C of the display module 200 may pass through the first space S1 and then enter the second space S2. The cable C entering the second space S2 may be connected to the control assembly 400.

In the related art, the rear cover is arranged to be coupled to the rear of the front cover to cover the entire rear side of the display module. In addition, the rear cover is provided to separate the display module from the control assembly. Accordingly, when covering the rear side of the display module using the rear cover during assembly of the display apparatus, it is required to pull out the cable of the display module through a hole formed in the rear cover. In other words, the cable connection process is not easy. In addition, since a separate cable hole needs to be formed in the rear cover not only in the display module, additional processes is required.

In comparison, the cable C of the display module 200 may be directly connected to the control assembly 400 (see FIG. 3). Since there is no separate cover that separates the display module 200 from the control assembly 400, the process of pulling out the cable C of the display module 200 through a hole formed in the separate cover may be omitted. When assembling the display apparatus, the cable C of the display module 200 may be connected to the control assembly 400 without interference with other components. As a result, the cable connection process of the display apparatus 1 may be facilitated. In addition, there is no need to form a separate cable hole in a component other than the display module 200.

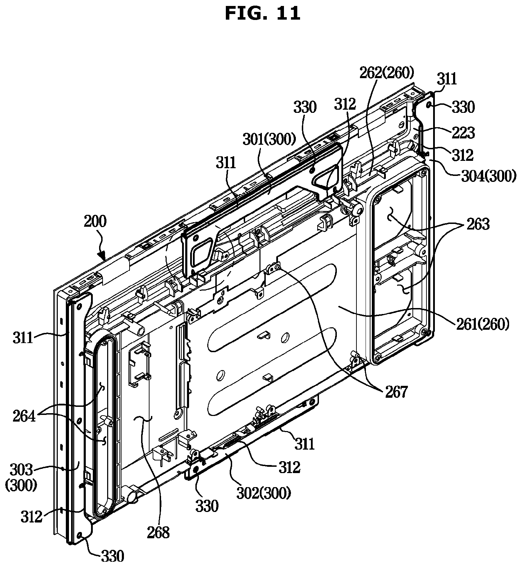

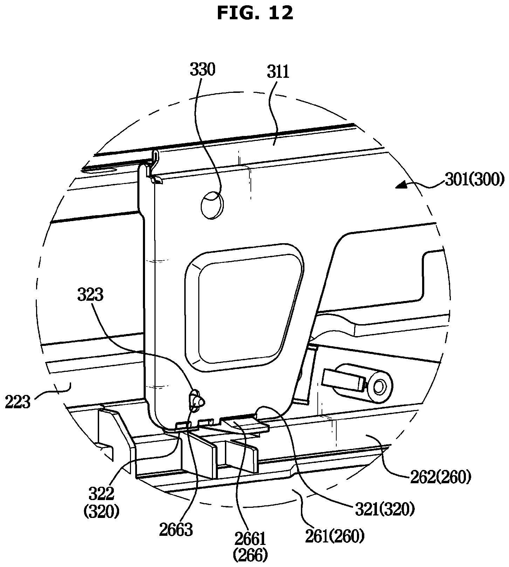

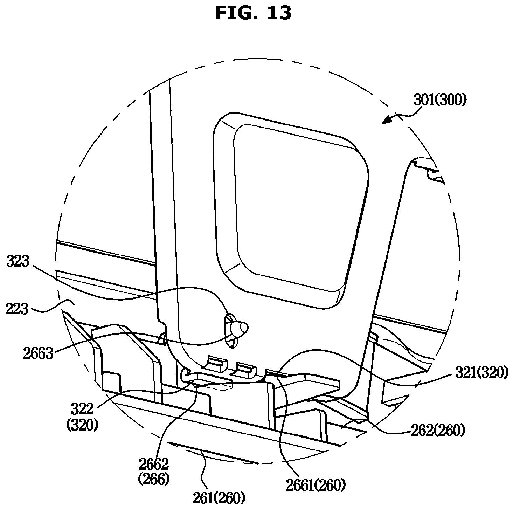

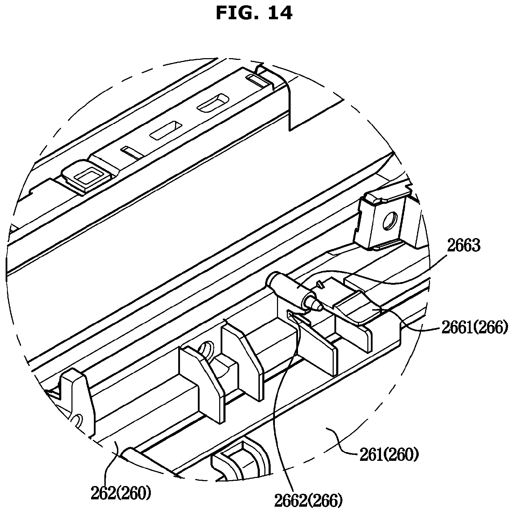

FIG. 11 is a drawing illustrating an example of a coupling state between a display module and a bracket. FIG. 12 is an enlarged view of a portion of FIG. 11. FIG. 13 is a view of the display module and bracket shown in FIG. 12, when viewed in a different direction. FIG. 14 is an enlarged view of a portion of an example of the display module.

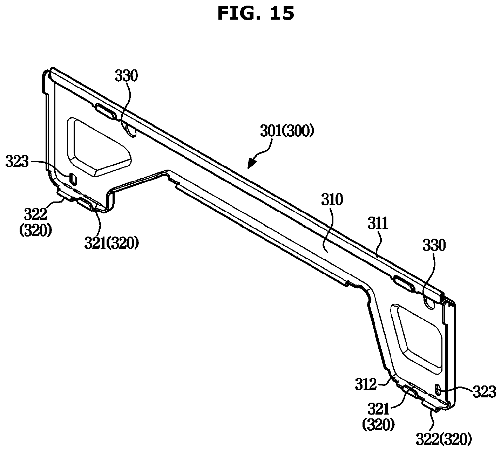

Hereinafter, with reference to FIGS. 11 to 15, a coupling structure of the first bracket 301 will be described. The coupling structure of the first bracket 301 may be applied to the second bracket 302, the third bracket 303, and the fourth bracket 304.

The bracket 300 may be provided at the rear of the display module 200. For example, the bracket 300 may be provided at the rear of the chassis 220. For example, the bracket 300 may be provided at the rear of the second chassis body 2232. For example, the bracket 300 may be arranged between the second chassis body 2232 and the rear cover 120. For example, the bracket 300 may be arranged between the side portion 113 of the housing 100 and the body portion 261 of the heat dissipation frame 260 (see FIGS. 9 and 10).

The bracket 300 may include a bracket body 310 forming the external appearance. The bracket body 310 may be provided to cover a part of the rear side of the display module 200.

The bracket 300 may have a shape extending along the side portion 113. The bracket body 310 may have a shape extending along the side portion 113. For example, the first bracket 301 and the second bracket 302 may have shapes extending in the left-right direction. For example, the third bracket 303 and the fourth bracket 304 may have shapes extending in the up-down direction.

The bracket 300 may be provided to fix the housing 100 and the display module 200. The bracket 300 may be provided to fix the front cover 110 and the display module 200. The bracket 300 may be provided to fix the front cover 110 and the rear cover 120.

For example, the bracket 330 may include a coupling hole 340. The coupling hole 340 may be provided to pass through the bracket body 310. For example, in a state in which the bracket 330 is coupled to the front cover 110 and the display module 200, the rear cover 120 may be coupled to the bracket 330 while covering the rear side of the display module 200. For example, a coupling hole 340 of the bracket 330 and a coupling hole 124 of the rear cover 120 may be provided to be mutually coupled by a fastening member 700.

For example, a first side 311 of the bracket 300 may be fixed to the housing 100. For example, the first side 311 of the bracket 300 may be inserted into the coupling groove 114 of the side portion 113. The first side 311 of the bracket 300 may be a side adjacent to the side portion 113. The first side 311 of the bracket 300 may be arranged to face relatively outward compared to a second side 312 described below.

For example, the first side 311 of the first bracket 301 may face upward. For example, a first side 311 of the second bracket 302 may face downward. For example, a first side 311 of the third bracket 303 may face right. For example, a first side 311 of the fourth bracket 304 may face left.

For example, the second side 312 of the bracket 300 may be fixed to the display module 200. For example, the second side 312 of the bracket 300 may be separably coupled to the heat dissipation frame 260 of the display module 200. The second side 312 of the bracket 300 may be the opposite side of the first side 311. The second side 312 of the bracket 300 may be arranged to face relatively inward compared to the first side 311.

For example, the second side 312 of the first bracket 301 may face downward. For example, a second side 312 of the second bracket 302 may face upward. For example, a second side 312 of the third bracket 303 may face left. For example, a second side 311 of the fourth bracket 303 may face right.

The bracket 300 may be separably mounted to the heat dissipation frame 260. The bracket 300 may be separably coupled to the heat dissipation frame 260.

For example, the bracket 300 may be hook-coupled to the rear surface 260b of the heat dissipation frame 260. The heat dissipation frame 260 may include a first coupling portion 266 formed on the rear surface 260b of the heat dissipation frame 260. The bracket 300 may include a second coupling portion 320 provided to be hook-coupled to the first coupling portion 266.

For example, the first coupling portion 266 of the heat dissipation frame 260 may include a locking protrusion 2661. The locking protrusion 2661 may protrude toward the rear side of the heat dissipation frame 260. The locking protrusion 2661 may have a shape extending in the forward-backward direction. The locking protrusion 2661 may have a shape in which a predetermined portion protrudes upward. The locking protrusion 2661 may be hook-coupled to a locking groove 231 that is described below.

For example, the second coupling portion 320 of the bracket 300 may include a locking groove 321. The locking groove 321 may be provided to correspond to the locking protrusion 2661. The locking groove 321 may be provided to engage with the locking protrusion 2661.

However, it is not limited to the example shown in the drawing, and the heat dissipation frame 260 may be provided to include a locking groove and the bracket 300 may be provided to include a locking protrusion.

For example, the first coupling portion 266 of the heat dissipation frame 260 may include a receiving groove 2662. The receiving groove 2662 may be recessed toward the front of the heat dissipation frame 260. The receiving groove 2662 may have a shape that is open toward the bracket 300.

For example, the second coupling portion 320 of the bracket 300 may include a protruding rib 322. The protruding rib 322 may be provided to correspond to the receiving groove 2662. The protruding rib 322 may be provided to be received in the receiving groove 2662. The protruding rib 322 may be provided to protrude toward the front of the heat dissipation frame 260. The protruding rib 322 may be hook-coupled to the receiving groove 2662.

However, the present disclosure is not limited to the example shown in the drawing, and the heat dissipation frame 260 may be provided to include a protruding rib and the bracket 300 may be provided to include a receiving groove.

For example, the heat dissipation frame 260 may include a guide protrusion 2663. The guide protrusion 2663 may be provided to protrude rearward of the heat dissipation frame 260. For example, the bracket 300 may include a guide hole 323. The guide hole 323 may be provided to correspond to the guide protrusion 2663. The guide protrusion 2663 may be received in the guide hole 323. The guide protrusion 2663 may be inserted into the guide hole 323. As the guide protrusion 2663 is inserted into the guide hole 323, the bracket 300 may be temporarily fixed to the heat dissipation frame 260. As the guide protrusion 2663 is inserted into the guide hole 323, the bracket 300 may be held on the heat dissipation frame 260. For example, in a state in which the guide protrusion 2663 is inserted into the guide hole 323, the first coupling portion 266 of the heat dissipation frame 260 and the second coupling portion 320 of the bracket 300 may be aligned.

However, the present disclosure is not limited to the example shown in the drawing, and the heat dissipation frame 260 may be provided to include a guide hole, and the bracket 300 may be provided to include a guide protrusion.

In the related art, a bracket is provided to fix the housing and the display module. However, in a process of coupling the bracket to each of the housing and the display module, a number of fastening parts and the like are required. For example, a separate bracket panel is required to mount the bracket to the rear of the display module.

In comparison, the bracket 300 may be easily mounted to the display module 200. For example, the first coupling portion 266 of the heat dissipation frame 260 and the second coupling portion 320 of the bracket 300 may be hook-coupled without a separate fastening part. For example, since the guide protrusion 2663 of the heat dissipation frame 260 and the guide hole 323 of the bracket 300 are aligned, the position adjustment of the bracket 300 becomes easier. Accordingly, the present disclosure may reduce the number of parts reduced during the bracket coupling process. In addition, the bracket coupling process may be performed more easily.

While the disclosure has been shown and described with reference to various embodiments thereof, it will be understood by those skilled in the art that various changes in form and details may be made therein without departing from the spirit and scope of the disclosure as defined by the appended claims and their equivalents.

## Claims

1. A display apparatus comprising:
a housing comprising an inlet;
a display module inside the housing; and
a control assembly configured to control the display module,
wherein the display module comprises:
a display panel configured to display an image;
a chassis supporting the display panel and covering a rear of the display panel; and
a heat dissipation frame between the chassis and the control assembly, the heat dissipation frame comprising a body portion spaced from a rear surface of the chassis and a fixing portion extended from the body portion and fixed to the rear surface of the chassis to form a heat exchange space in which external air introduced through the inlet flows.

2. The display apparatus of claim 1, further comprising a sealing member configured to seal between the chassis and the fixing portion of the heat dissipation frame.

3. The display apparatus of claim 2, wherein the fixing portion further comprises a sealing member mounting portion that is open toward the rear surface of the chassis and into which the sealing member is inserted.

4. The display apparatus of claim1, wherein the fixing portion is in contact with the rear surface of the chassis.

5. The display apparatus of claim 1, wherein the fixing portion extends along an edge of the body portion.

6. The display apparatus of claim 1, wherein the chassis comprises:
a first chassis body covered by the heat dissipation frame; and
a second chassis body exposed to a rear of the heat dissipation frame.

7. The display apparatus of claim 6, wherein the display module further comprises a cable that passes through the second chassis body and is electrically connected to the control assembly.

8. The display apparatus of claim 1, further comprising a bracket detachably mountable to the heat dissipation frame and configured to fix the housing and the display module.

9. The display apparatus of claim 8, the heat dissipation frame further comprises a first coupling portion on a rear surface of the heat dissipation frame, and
wherein the bracket further comprises a second coupling portion hook-coupled to the first coupling portion.

10. The display apparatus of claim 9, wherein the first coupling portion comprises a locking protrusion protruding toward a rear of the heat dissipation frame, and
wherein the second coupling portion comprises a locking groove configured to engage with the locking protrusion.

11. The display apparatus of claim 9, wherein the first coupling portion further comprises a receiving groove recessed toward a front of the heat dissipation frame, and
wherein the second coupling portion further comprises a protruding rib protruding toward the front of the heat dissipation frame to be received in the receiving groove.

12. The display apparatus of claim 8, wherein the heat dissipation frame further comprises a guide protrusion protruding toward a rear of the heat dissipation frame,
wherein the bracket further comprises a guide hole corresponding to the guide protrusion, and
wherein the bracket is configured to be held on the heat dissipation frame as the guide protrusion is inserted into the guide hole.

13. The display apparatus of claim 1, wherein the housing comprises a front cover arranged to protect a front of the display module; and
a rear cover coupled to a rear of the front cover and covering a rear of the display module and the control assembly, and
wherein a first space between the chassis and the rear cover is communicable with a second space between the heat dissipation frame and the rear cover.

14. The display apparatus of claim 1, wherein the heat dissipation frame is injection-molded.

15. The display apparatus of claim 1, wherein the heat dissipation frame comprises a plastic material.
